(19) Europäisches Patentamt / European Patent Office / Office européen des brevets

(11) **EP 3 681 040 B1**

(12) **FASCICULE DE BREVET EUROPEEN**

(45) Date de publication et mention de la délivrance du brevet:
**31.07.2024 Bulletin 2024/31**

(21) Numéro de dépôt: **20150401.6**

(22) Date de dépôt: **07.01.2020**

(51) Classification Internationale des Brevets (IPC):
**H03M 7/30** (2006.01)  **H04L 5/00** (2006.01)
**H04L 27/26** (2006.01)  **H04J 13/00** (2011.01)

(52) Classification Coopérative des Brevets (CPC):
**H03M 7/3062; H03M 7/3068; H04J 13/0059; H04L 5/0008; H04L 27/0004; H04L 27/2642**

(54) **MÉTHODE D'ÉCHANTILLONNAGE PASSE-BANDE PAR ONDELETTES MODULÉES EN POSITION**

BANDPASS-ABTASTUNGSMETHODE MITHILFE VON POSITIONSMODULIERTEN WAVELETS

METHOD FOR BANDPASS SAMPLING BY WAVELETS MODULATED IN POSITION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **09.01.2019 FR 1900181**

(43) Date de publication de la demande:
**15.07.2020 Bulletin 2020/29**

(73) Titulaire: **Commissariat à l'énergie atomique et aux énergies alternatives
75015 Paris (FR)**

(72) Inventeurs:
• **PELISSIER, Michaël
38054 GRENOBLE (FR)**
• **MARNAT, Marguerite
38054 GRENOBLE (FR)**

(74) Mandataire: **Brevalex
56, Boulevard de l'Embouchure
B.P. 27519
31075 Toulouse Cedex 2 (FR)**

(56) Documents cités:
**EP-A1- 3 319 236**

• **MARGUERITE MARNAT: "Radiofrequency receivers based on compressive sampling for feature extraction in cognitive radio applications", 29 November 2018 (2018-11-29), XP055625669, Retrieved from the Internet <URL:https://hal.archives-ouvertes.fr/tel-0200666 4/document> [retrieved on 20190924]**

• **ANONYMOUS: "Constant amplitude zero autocorrelation waveform - Wikipedia", 2 November 2016 (2016-11-02), XP055625691, Retrieved from the Internet <URL:https://en.wikipedia.org/w/index.php?title =Constant_amplitude_zero_autocorrelation_wa veform&oldid=747454938> [retrieved on 20190924]**

• **MICHA\"EL PELISSIER ET AL: "Non-Uniform Wavelet Sampling for RF Analog-to-Information Conversion", ARXIV.ORG, CORNELL UNIVERSITY LIBRARY, 201 OLIN LIBRARY CORNELL UNIVERSITY ITHACA, NY 14853, 4 September 2017 (2017-09-04), XP080818080**

• **KEZHI LI ET AL: "Convolutional Compressed Sensing Using Deterministic Sequences", IEEE TRANSACTIONS ON SIGNAL PROCESSING, IEEE SERVICE CENTER, NEW YORK, NY, US, vol. 61, no. 3, 1 February 2013 (2013-02-01), pages 740 - 752, XP011487881, ISSN: 1053-587X, DOI: 10.1109/TSP.2012.2229994**

• **ANONYM: "Arrêté du 25 mai 2016 fixant le cadre national de la formation et les modalités conduisant à la délivrance du diplôme national de doctorat", 27 May 2016 (2016-05-27), pages 1 - 1, XP093087784, Retrieved from the Internet <URL:https://www.legifrance.gouv.fr/loda/article _lc/LEGIARTI000042487965/2019-01-09/> [retrieved on 20231002]**

EP 3 681 040 B1

**Description**

**DOMAINE TECHNIQUE**

La présente invention concerne de manière générale le domaine de l'acquisition compressée et plus particulièrement celui du sous-échantillonnage passe-bande associée à une projection du signal sur ondelettes en encore dénommée WBS (*Wavelet Bandpass Sampling*).

**ÉTAT DE LA TECHNIQUE ANTÉRIEURE**

Une des techniques prometteuses pour faire face à l'augmentation considérable de la quantité de données générées par les réseaux de capteurs est l'acquisition compressée ou CS (*Compressive Sensing*), encore dénommée *compressed sampling* ou *sparse sampling*.

L'acquisition compressée repose sur le fondement théorique suivant : un signal qui présente des critères de parcimonie spectrale dans une bande donnée, c'est-à-dire dont l'information n'est pas contenu dans l'intégralité de la bande en question, peut être échantillonné sans perte à condition que sa fréquence d'échantillonnage soit proche de la fréquence de Landau, c'est-à-dire de sa largeur de bande d'information effective

On rappelle tout d'abord, qu'en règle générale, l'échantillonnage d'un signal à une fréquence inférieure à la fréquence de Nyquist, $f_{Nyq} = 2f_{max}$, où $f_{max}$ est la plus haute fréquence présente dans le spectre du signal, conduit à un repliement spectral et donc à une impossibilité de reconstruire le signal initial. Lorsque le signal est échantillonné à la fréquence de Nyquist sur un intervalle d'acquisition donné (de temps ou d'espace), $T_{acq}$, il peut être représenté par un vecteur **x** de taille $N = f_{Nyq} \cdot T_{acq}$, dans la base canonique (instants de cet intervalle temporel ou points de cet intervalle spatial) de ce domaine.

Toutefois, lorsque la représentation du signal est $K$ - parcimonieuse dans un domaine dual donné (généralement le domaine fréquentiel), c'est-à-dire si ce signal est représenté par $K$ composantes non nulles dans une base de ce domaine (généralement une base de Fourier), ce signal peut être reconstruit à partir de $M$ mesures dépendant linéairement de ces composantes, où $M$ est de l'ordre de $K \log N$ . Plus précisément, si l'on note **y** le vecteur dont les éléments sont ces $M$ mesures linéaires, il peut être exprimé de la manière suivante :

$$\mathbf{y} = \mathbf{\Phi}\mathbf{x} = \mathbf{\Phi}\mathbf{\Psi}\mathbf{s} \tag{1}$$

où s est la représentation $K$ - parcimonieuse dans une base du domaine dual, $\Psi$ est une matrice de transformation (ou *sparsity matrix*) de taille $N \times N$ permettant de passer de la base du domaine dual à la base canonique et $\Phi$ est la matrice de mesure (ou matrice d'acquisition) de taille $M \times N$, avec $M \ll N$ traduisant ainsi la réduction de dimensionnalité. La matrice $\Phi$ peut s'écrire sous la forme $\Phi = \mathbf{R}_T \mathbf{I}_N$ où $\mathbf{R}_T$ représente une sélection aléatoire de $M$ lignes parmi $N$ de la matrice identité $\mathbf{I}_N$, autrement dit la sélection aléatoire $M$ échantillons parmi $N$ .

Différentes méthodes d'acquisition compressée ont été envisagées. La première est celle d'un échantillonnage non-uniforme ou NUS (*Non Uniform Sampling*). Selon cette méthode, le signal est échantillonné à des intervalles irréguliers en ne sélectionnant que certains échantillons en sortie d'un échantillonneur conventionnel à la fréquence de Nyquist. Toutefois cette méthode nécessite d'utiliser un échantillonneur à la fréquence de Nyquist, voire plusieurs échantillonneurs en parallèle à une fréquence d'échantillonnage inférieure mais nécessitant une horloge de synchronisation à la fréquence de Nyquist. En outre, l'échantillonneur non-uniforme reste très sensible à la gigue d'horloge. Enfin, malgré la réduction de la cadence moyenne des échantillons, il n'en demeure pas moins que la bande passante analogique de l'échantillonneur doit être importante pour ne pas filtrer le signal. Ceci peut s'avérer problématique en termes de réalisation dans un contexte applicatif très large bande pouvant aller jusqu'à la centaine de GHz.

Lorsque le signal à échantillonner est un signal RF multi-bande, on préfère utiliser une méthode d'acquisition plus adaptée, à savoir un sous-échantillonnage passe-bande (dit encore échantillonnage de bande passante) non-uniforme par ondelettes ou NUWBS (*Non Uniform Wavelet Bandpass Sampling*). Celle-ci utilise un dictionnaire de fonctions élémentaires formant une base, voire une famille génératrice (*overcomplete*) de $L^2(\mathbb{R})$ , dénommées ci-après ondelettes, dont les fréquences centrales sont respectivement situées dans les sous-bandes du signal RF.

Ce signal est corrélé avec une séquence d'ondelettes se succédant à la cadence $f_s = \dfrac{f_{Nyq}}{\gamma} \ll f_{Nyq}$ , où $\gamma$ est un facteur de sous-échantillonnage défini plus loin. Seuls certains résultats en sortie du corrélateur (fournis tous les $T_s = 1/f_s$) sont retenus en sortie du corrélateur.

Dans ce cas, en utilisant le même formalisme que précédemment :

$$\mathbf{y} = \mathbf{R}_T \mathbf{W}^H \mathbf{F}^{-1} \mathbf{s} = \mathbf{R}_T \mathbf{A} \mathbf{s} \qquad (2)$$

avec $\mathbf{A} = \mathbf{W}^H \mathbf{F}^{-1} = (\mathbf{FW})^H$ où $\mathbf{F}$ est la matrice représentant la transformée de Fourier discrète ($\mathbf{F}^H = \mathbf{F}^{-1}$) de taille $N$, et $\mathbf{W}$ est une matrice de taille $N \times N_s$ dont chacune des colonnes (et donc chacune des lignes de $\mathbf{W}^H$) représente une ondelette dans la base canonique et chacune des lignes représente un instant d'échantillonnage et où $\mathbf{R}_T$ est une matrice de sélection de $M$ lignes parmi $N_s$ de la matrice d'acquisition $\mathbf{A}$. De manière similaire, chaque ligne de la matrice $\mathbf{A}$ correspond à un élément du dictionnaire et chaque colonne à un instant d'échantillonnage. La matrice $\mathbf{A}$ représente la conjuguée hermitienne de la transformée de Fourier de chacune des ondelettes.

On trouvera une description détaillée de la méthode d'acquisition NUWBS dans la demande EP-A-3319236 et dans l'article de M. Pelissier et al. intitulé « Non-uniform wavelet sampling for RF analog-to-information conversion », IEEE Transactions on Circuits and Systems I, Aug. 2017.

La particularité de la méthode NUWBS réside dans le fait de pouvoir générer les ondelettes et d'en effectuer la corrélation avec le signal RF de manière analogique. Les résultats de corrélation sont fournis par le corrélateur à la cadence $f_s$ et ces résultats sont échantillonnés de manière non uniforme. La méthode NUWBS est avantageuse au sens où la corrélation avec l'ondelette est réalisée en analogique, avant échantillonnage, ce qui permet de réduire drastiquement les contraintes du convertisseur analogique/ numérique en termes de bande passante et de cadence d'échantillonnage.

Le facteur de sous-échantillonnage $\gamma$ dépend de la largeur agrégée, $B_{agg}^w$, des $N_b$ sous-bandes du signal RF, soit :

$$\gamma = \frac{f_{Nyq}}{B_{agg}^w} = \frac{f_{Nyq}}{\sum_{i=1}^{N_b} B_i^w} \qquad (3)$$

où $B_i^w$, $i = 1, ..., N_b$ sont les largeurs des sous-bandes du signal RF. Le fait que seuls certains échantillons (c'est-à-dire résultats de corrélation) puissent être retenus en sortie du corrélateur (échantillonnage non-uniforme) provient du fait que certaines des bandes peuvent être lacunaires et donc que la fréquence de Landau est inférieure à $f_s$. Toutefois, lorsque que ces sous-bandes sont entièrement occupées, on se contentera d'un échantillonnage uniforme de tous les résultats à la cadence $f_s$.

Les fonctions élémentaires utilisées pour la décomposition dans l'espace dual sont par exemple fonctions de Gabor ou des ondelettes de Morlet. On appellera ici ondelettes des fonctions dont le support temporel borné et dont la fréquence centrale est réglable.

Les fonctions de Gabor sont définies dans le domaine temporel par :

$$\psi_{f_v^c, \delta_k}(t) = \left(\frac{2}{\pi}\right)^{\frac{1}{4}} \frac{1}{\sqrt{\tau}} e^{2\pi j f_v^c (t - \delta_k)} e^{-\left(\frac{t - \delta_k}{\tau}\right)^2} \qquad (4)$$

On comprend ainsi qu'une fonction de Gabor $\psi_{f_v^c, \delta_k}(t)$ est définie sur support temporel borné de largeur, centré sur l'instant $\delta_k$ et de fréquence centrale $f_v^c$.

Le dictionnaire utilisé est alors composé de la famille $\{\psi_{jb,ka}(t)\}$ où $a$ est un intervalle de discrétisation dans le temps et $b$ un intervalle de discrétisation en fréquence. Typiquement, $a$ est égal à $1/f_{NYQ}$ ou égal à $1/T_s$ dans le cas de système sous-échantillonnage passe-bande par ondelette.

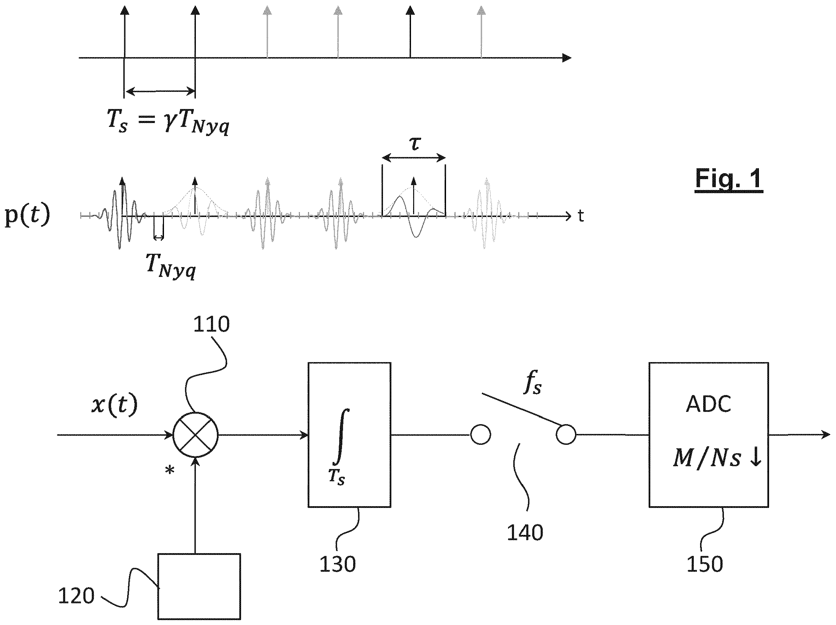

La Fig. 1 représente de manière schématique un échantillonneur utilisant la méthode d'échantillonnage NUWBS connue de l'état de la technique.

On a représenté sur la partie haute de la figure une séquence d'ondelettes se succédant à la cadence $f_p = 1/T_p$,

notée *p(t),* générée par le générateur analogique 120. Cette séquence est multipliée (produit scalaire hermitien) avec le signal RF, *x(t)*, le produit hermitien étant intégré en 130 sur un intervalle de durée $T_i$ ($T_i \leq T_p$). Les résultats de corrélation en sortie de l'intégrateur 130 sont échantillonnés à la fréquence $f_p$ puis décimés de manière non uniforme d'un facteur de décimation $N_s/M$ dans le convertisseur ADC, 150, pour obtenir une séquence d'échantillons représentative du signal RF à la cadence moyenne $f_s = M/T_{acq}$ qui peut être rendue aussi proche que souhaité de la fréquence de Landau. Des variantes de cet échantillonneur NUWBS à plusieurs branches de corrélation et d'échantillonnage ont été également décrites dans la demande EP-A-3319236 précitée.

Quel que soit la variante envisagée, l'échantillonneur NUWBS permet d'obtenir des taux de compression proches de la valeur théorique de Landau. Toutefois, de manière similaire à ce qui se passe dans le sous-échantillonnage passe-bande conventionnelle, un repliement spectral intervient du fait du sous-échantillonnage par rapport à la fréquence de Nyquist.

Pour illustrer l'effet du repliement spectral dans un échantillonneur WBS non-uniforme (NUWBS), voire uniforme (UWBS), c'est-à-dire correspondant au cas où le facteur de décimation est égal à 1, on se placera dans le cas où toutes les ondelettes ont la même fréquence centrale et ne diffèrent que par leurs décalages temporels. On note $\psi(t)$ la forme

$$p(t) = \psi(t) \otimes \sum_{k=0}^{\infty} \delta\left(t - T_p\right)$$

d'onde commune à ces ondelettes et $\qquad$ la séquence d'ondelettes supposée ici infinie.

Dans ce cas, le signal en sortie du corrélateur peut être représenté dans le domaine spectral par :

$$Y(f) = X(f) \otimes H^*(-f) \tag{5}$$

avec :

$$H(f) = \sum_{k=0}^{\infty} H_k(f) = \sum_{k=0}^{\infty} \Psi(kf_p)\delta\left(f - kf_p\right) \tag{6}$$

où $X(f)$ et $Y(f)$ sont les spectres respectifs de x(t) et y(t), et où $\Psi(f)$ et $H(f)$ sont respectivement les spectres de $\psi(t)$ et de $p(t)$.

Si l'on considère désormais deux composantes spectrales de X(f) situées aux fréquences $f_L = f_{BB} + nf_p$ et $f_U = f_{BB} + (n+1)f_p$ avec $-f_p/2 < f_{BB} \leq f_p/2$ et si l'on suppose que l'on échantillonne les résultats de corrélation à la fréquence $f_s = f_p$ (c'est-à-dire que l'on effectue un échantillonnage uniforme sans décimation), ces deux composantes seront repliées sur la même fréquence $f_{BB}$ après échantillonnage, puisque :

$$Y(z = e^{j2\pi fT_p}) = \sum_{k=0}^{K-1} Y\left(e^{j2\pi T_{Nyq}\left(\frac{f - kf_p}{K}\right)}\right) \tag{7}$$

avec

$$K = \frac{f_{Nyq}}{f_s} = \frac{f_{Nyq}}{f_p},$$

puisque

$$f_U - (k+1)f_p = f_L - kf_p.$$

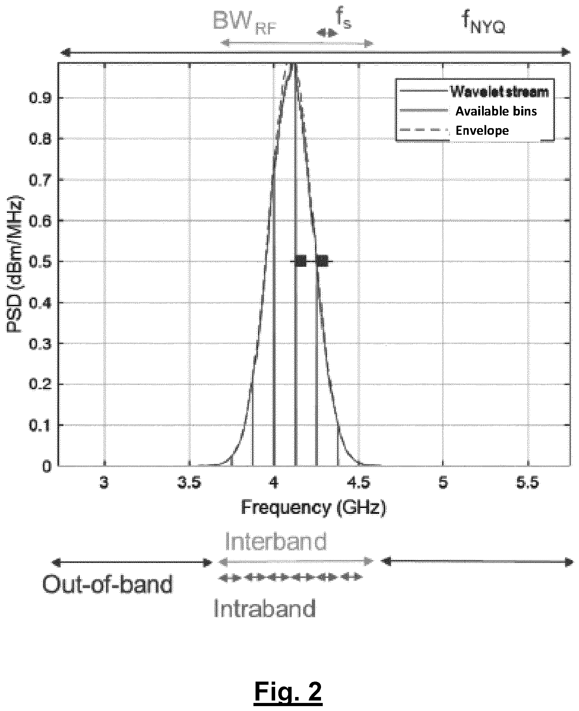

La Fig. 2 représente le spectre de la séquence d'ondelettes, $H(f)$, dans la bande de Nyquist du signal d'entrée, x(t). Le spectre $H(f)$ est centré sur une sous-bande du signal RF, de largeur $BW_{RF}$. On a également représenté sur la figure la fréquence de Nyquist, $f_{Nyq}$ du signal x(t) ainsi que la fréquence d'échantillonnage en sortie du corrélateur, soit

ici $f_s = f_p$.

La convolution du spectre de raies $H(f)$ avec celui du signal dans la sous-bande, puis le repliement spectral dans l'intervalle $\left[-\dfrac{f_p}{2}, +\dfrac{f_p}{2}\right]$ conduit à distinguer deux zones spectrales : une première zone, 210, correspondant sensiblement à la sous-bande, donnant lieu à un aliasing de type intrabande et une seconde zone, 220, extérieure à cette enveloppe spectrale n'apportant pas de contribution au spectre du signal échantillonné. Plus précisément, une composante spectrale à $f_{in}$ de la sous-bande donne, après convolution avec $H(f)$, le même spectre $H(f)$ centré sur la fréquence $f_c$ - $f_{in} = f_{BB}$ mod.$f_p$ où $f_c$ est la fréquence centrale de l'ondelette. Après échantillonnage à $f_p$, les composantes $H(f_{BB} + mf_p)$ se retrouvent toutes repliées sur la fréquence $f_{BB}$. En revanche, une fréquence $f_{out}$ située en dehors de la sous-bande donne, après convolution avec $H(f)$, une valeur nulle et n'apporte donc pas de contribution au spectre du signal échantillonné.

On remarque que, du fait du filtrage par $\Psi(f)$, le nombre de raies dans l'enveloppe spectrale de $H(f)$ est limité (d'un facteur égal au rapport entre la largeur de l'enveloppe spectrale de l'ondelette et de la fréquence de répétition $f_p$) et la plupart d'entre elles sont de faible puissance. L'aliasing est réduit par rapport à un échantillonnage de bande spectrale conventionnel (c'est-à-dire, sans corrélation avec des ondelettes et donc dans lequel toutes les raies contribuent, $\Psi(f)=1$) mais reste néanmoins présent, notamment lorsque l'on utilise des ondelettes de durée brève au regard de leur période de répétition. Ce repliement (*aliasing*) conduit à une perte d'information liée à l'ambiguïté des raies spectrales repliées et par conséquent à une distorsion du signal reconstruit à partir du train d'échantillons.

Le but de la présente invention est de proposer une méthode d'échantillonnage passe-bande par ondelettes, uniforme ou non-uniforme, ne présentant qu'un repliement réduit, et permettant par conséquent une très bonne reconstruction du signal à partir du train d'échantillons. Un autre but de la présente invention est de proposer une implémentation simple de cette méthode d'échantillonnage.

## EXPOSÉ DE L'INVENTION

La présente invention est définie par une méthode d'échantillonnage passe-bande d'un signal analogique, le spectre dudit signal présentant un ensemble de sous-bandes, ledit signal étant corrélé avec une séquence d'ondelettes se succédant avec une cadence $f_p$ égale à la somme des largeurs desdites sous-bandes, les fréquences centrales des ondelettes appartenant aux dites sous-bandes, dans laquelle les positions respectives des ondelettes dans la séquence sont modulées temporellement au moyen des arguments des éléments successifs d'une séquence CAZAC, les résultats de corrélation avec la séquence d'ondelettes ainsi modulées en position étant échantillonnés avec une fréquence $f_s \leq f_p$ et convertis en numérique.

La séquence d'ondelettes est typiquement formée d'une pluralité de séquences de base, chaque séquence de base étant de durée $\Sigma T_p$ avec $T_p = 1/f_p$, la séquence CAZAC étant de longueur $\Sigma$, les positions respectives des ondelettes dans une séquence de base étant modulées temporellement au moyen des arguments des éléments successifs de la séquence CAZAC.

Plus précisément, la séquence CAZAC est formée par les éléments complexes $\eta_k$, $k = 1,..,\Sigma$ où les positions temporelles des ondelettes de la séquence sont les instants $kT_p + \varepsilon_k$ avec $T_p = 1/f_p$ et $\varepsilon_k = \dfrac{\arg\left(\varepsilon_k\right)}{2\pi f_c^v}$, où $f_c^v$ est la fréquence centrale des ondelettes.

Dans un mode préféré de réalisation, la séquence CAZAC est une séquence de Zadoff-Chu dont les éléments sont définis par :

$$ZC_R(k) = e^{-j\pi Rk(k-1)/\Sigma} \quad ,$$

si la longueur $\Sigma$ de la séquence est impaire, et

$$ZC_R(k) = e^{-j\pi R(k-1)(k-1)/\Sigma} \quad ,$$

si la longueur $\Sigma$ de la séquence est paire et où $R,\Sigma$ sont des entiers positifs premiers entre eux, $R$ représentant l'excursion de la fréquence instantanée, exprimée comme multiple de $f_p$, le long de la séquence et $k \in [1,\Sigma]$.

La séquence d'ondelettes peut être formée d'au moins une première et une seconde séquence de base, la première séquence de base étant constituée d'ondelettes dont les positions sont modulées temporellement au moyen des arguments des éléments successifs d'une première séquence CAZAC et la seconde séquence de base étant constituée d'ondelettes dont les positions sont modulées temporellement au moyen des arguments des éléments successifs d'une seconde séquence CAZAC, les première et seconde séquences CAZAC étant de même longueur mais d'excursions de fréquence instantanée distinctes.

Le spectre du signal analogique peut comprendre une première et une seconde sous-bande, la séquence d'ondelettes étant alors formée d'au moins une première et une seconde séquence de base, la première étant constituée d'ondelettes dont la fréquence centrale appartient à la première sous-bande et la seconde étant constituée d'ondelettes dont la fréquence centrale appartient à la seconde sous-bande.

Les ondelettes peuvent être des fonctions de Gabor ou des ondelettes de Morlet.

L'invention est également définie par un dispositif d'échantillonnage passe-bande d'un signal analogique par échantillonnage de bande passante, le spectre dudit signal présentant un ensemble de sous-bandes, le dispositif comprenant au moins une branche d'échantillonnage comportant :

un générateur de séquence d'ondelettes, les ondelettes de ladite séquence se succédant avec une cadence $f_p$ égale à la somme des largeurs desdites sous-bandes ;

un corrélateur pour corréler le signal analogique avec ladite séquence d'ondelettes et fournir des résultats de corrélation à la cadence $f_p$ ;

un échantillonneur pour échantillonner les résultats de corrélation à la cadence $f_p$ ;

un convertisseur analogique numérique pour décimer et convertir en numérique les résultats de corrélation ainsi échantillonnés ;

le dispositif d'échantillonnage comprenant en outre :

un modulateur de position temporelle destiné à moduler les positions temporelles des ondelettes de la séquence d'ondelettes générée par le générateur, avant corrélation avec le signal analogique, la modulation temporelle étant réalisée au moyen des arguments des éléments successifs d'une séquence CAZAC.

Selon un mode préféré de réalisation, la séquence CAZAC est une séquence de Zadoff-Chu dont les éléments sont définis par :

$$ZC_R(k) = e^{-j\pi Rk(k-1)/\Sigma} \quad ,$$

si la longueur $\Sigma$ de la séquence est impaire, et

$$ZC_R(k) = e^{-j\pi R(k-1)(k-1)/\Sigma} \quad ,$$

si la longueur $\Sigma$ de la séquence est paire et où

$R,\Sigma$ sont des entiers positifs premiers entre eux, $R$ représentant l'excursion de la fréquence instantanée, exprimée comme multiple de $f_p$, le long de la séquence et $k \in [1,\Sigma]$.

Selon un exemple avantageux d'implémentation, le générateur de séquence d'ondelettes comprend un oscillateur VCO commuté par un signal de commutation, l'oscillateur VCO comprenant :

un circuit oscillant dont la fréquence est commandée pour être égale à la fréquence centrale des ondelettes de la séquence ;

une paire de transistors croisés, montés entre les bornes du circuit oscillant ;

une source de courant commune, la source de courant étant commutée par le signal de commutation ;

un générateur d'horloge pour générer un signal d'horloge à la fréquence $f_p$ ;

un modulateur de fréquence pour moduler linéairement la fréquence du signal d'horloge de manière à ce que celle-ci varie linéairement du début à la fin de la séquence d'ondelettes avec une excursion de $Rf_p$.

Le générateur de séquence d'ondelettes peut comprendre en outre un module de mise en forme d'impulsion, transformant chaque impulsion du signal d'horloge en une impulsion ayant la forme d'onde d'une ondelette.

Les ondelettes peuvent être des fonctions de Gabor ou des ondelettes de Morlet.

## BRÈVE DESCRIPTION DES DESSINS

D'autres caractéristiques et avantages de l'invention apparaîtront à la lecture d'un mode de réalisation préférentiel de l'invention, décrit en référence aux figures jointes parmi lesquelles :

[Fig. 1], déjà décrite, représente de manière schématique un échantillonneur utilisant une méthode d'échantillonnage WBS connue de l'état de la technique ;
[Fig. 2] représente le spectre de la séquence d'ondelettes utilisée dans l'échantillonneur de la Fig. 1 dans le cas d'un échantillonnage uniforme (UWBS);
[Fig. 3A] et [Fig. 3B] représentent l'évolution de la phase instantanée, à chaque début d'impulsion, ainsi que de la fréquence instantanée le long d'une séquence de Zadoff-Chu ;
[Fig. 4A] et [Fig. 4B] représentent respectivement des composantes de phase et des composantes fréquentielles d'une séquence d'ondelettes modulées en position temporelle par une séquence de Zadoff-Chu ;
[Fig. 5] représente le spectre d'une séquence d'ondelettes modulées en position temporelle par une séquence de Zadoff-Chu ;
[Fig. 6] représente de manière schématique un exemple de matrice d'acquisition utilisée dans le cadre d'une méthode d'échantillonnage ΔWBS selon la présente invention ;
[Fig. 7] représente de manière schématique un échantillonneur ΔWBS selon un premier mode de réalisation de la présente invention ;
[Fig. 8] représente de manière schématique un échantillonneur ΔWBS selon un second mode de réalisation de la présente invention ;
[Fig. 9] représente un exemple de séquence d'ondelettes modulées en position par une séquence CAZAC ;
[Fig. 10] représente de manière schématique un générateur de séquence d'ondelettes modulées en PPM au moyen d'une séquence de Zadoff-Chu pour l'échantillonneur ΔWBS de la Fig. 7 ou de la Fig. 8 ;

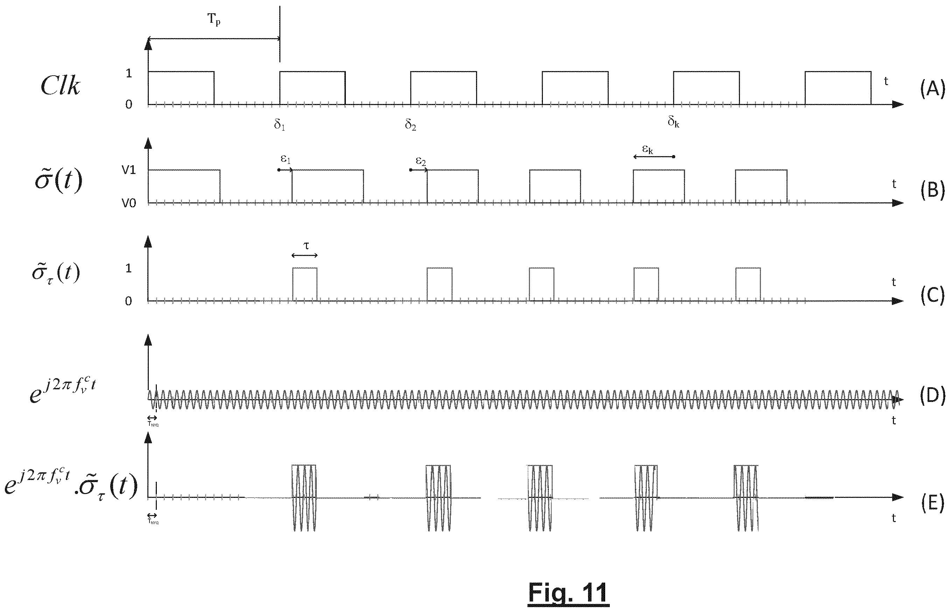

[Fig. 11] représente des signaux en différents points du générateur de la Fig. 10.

## EXPOSÉ DÉTAILLÉ DE MODES DE RÉALISATION PARTICULIERS

Nous considérerons dans la suite un échantillonneur WBS (*Wavelet Bandpass Sampling*), de type uniforme ou non-uniforme. On rappelle que les ondelettes utilisées par cet échantillonneur sont des fonctions élémentaires dont le support temporel est borné et dont la fréquence centrale est réglable, ces fonctions formant une base voire un ensemble surcomplet de $L^2(\mathbb{R})$. Nous supposerons également, dans un but d'illustration et sans perte de généralité, que les ondelettes en question sont des fonctions de Gabor, telles que définies plus haut. Alternativement, elles pourront être par exemple des ondelettes de Morlet voire des ondelettes de Haar. Le signal d'entrée est corrélé avec une séquence d'ondelettes se succédant à la cadence $f_p$ et les résultats de corrélation ainsi obtenus pour les différentes ondelettes sont échantillonnés à une fréquence d'échantillonnage $f_s$ qui peut être égale à $f_p$ (échantillonnage uniforme) ou bien être inférieure à celle-ci (échantillonnage non uniforme).

L'idée à la base de la présente invention est d'effectuer une modulation des positions temporelles des ondelettes, appelée aussi PPM (*Puise Position Modulation*) au moyen d'une séquence de modulation dérivée d'une séquence CAZAC (*Constant Amplitude Zero Auto-Correlation*) de manière à rompre la cohérence de phase des raies spectrales du signal formé par la séquence d'ondelettes, avant le repliement du spectre dû à l'échantillonnage.

On rappelle qu'une séquence CAZAC est caractérisée par le fait que tous ses éléments sont de même module et que son autocorrélation cyclique est un Dirac centré sur zéro. Autrement dit, la corrélation cyclique d'une séquence CAZAC avec cette même séquence décalée est nulle sauf lorsque ce décalage est lui-même nul auquel cas le résultat de la corrélation est égal à 1.

Plus précisément, si l'on considère une fréquence centrale donnée $f_v^c$ et une séquence CAZAC $\eta_1,...,\eta_\Sigma$ (où $\eta_1,...,\eta_\Sigma$ sont des valeurs complexes) la séquence de modulation PPM, $\varepsilon_1,...,\varepsilon_\Sigma$, est obtenue au moyen de :

$$\varepsilon_k = \frac{1}{2\pi f_v^c}\arg(\eta_k), \quad k=1,...,\Sigma \tag{8}$$

$$p(t) = \sum_{k=1}^{\Sigma} \psi_{f_v^c, \delta_k}(t)$$

Si l'on considère maintenant une séquence d'ondelettes , la séquence obtenue après modulation PPM peut s'exprimer par :

$$\tilde{p}(t) = \sum_{k=1}^{\Sigma} \psi_{f_v^c, \delta_k}(t - \varepsilon_k) \tag{9}$$

$$\psi_{f_v^c, \delta_k}(t) = \left(\frac{2}{\pi}\right)^{\frac{1}{4}} \frac{1}{\sqrt{\tau}} e^{2\pi j f_v^c (t - \delta_k)} e^{-\left(\frac{t - \delta_k}{\tau}\right)^2}$$

où dans le cas où l'on utilise des fonctions de Gabor.

La durée de la séquence $\tilde{p}(t)$ est de $T_{acq} = \Sigma T_p$ où $f_p = 1/T_p$ est la cadence à laquelle se succèdent les ondelettes. La séquence $\tilde{p}(t)$ peut être elle-même répétée à la cadence $f_{acq} = 1/T_{acq}$.

Si l'on suppose que les d'ondelettes de la séquence sont de même fréquence centrale $f_v^c$ et notant $\psi(t)$ la forme d'onde commune, c'est-à-dire $\psi_{f_v^c, \delta_k}(t) = \psi(t - \delta_k)$, la séquence d'ondelettes après modulation PPM s'écrit :

$$\tilde{p}(t) = \sum_{k=1}^{\Sigma} \psi(t - kT_p - \varepsilon_k) = \psi(t) \otimes \sum_{k=1}^{\Sigma} \delta(t - kT_p - \varepsilon_k) \tag{10}$$

où $\otimes$ représente le produit de convolution.

A titre d'exemple de séquences CAZAC, on choisira avantageusement les séquences de Zadoff-Chu (ZC) définies par :

$$ZC_R(k) = e^{-j\pi Rk(k-1)/\Sigma} \quad ,$$

si la longueur $\Sigma$ de la séquence est impaire, et

$$ZC_R(k) = e^{-j\pi R(k-1)(k-1)/\Sigma} \quad ,$$

si la longueur $\Sigma$ de la séquence est paire et où

$R$, $\Sigma$ étant des entiers positifs premiers entre eux (c'est-à-dire pgcd($R,\Sigma$) =1), $-R/\Sigma$ étant la pente de la fréquence instantanée le long de la séquence et $k \in [1, \Sigma]$.

Si l'on choisit une séquence ZC de longueur paire, les éléments de la séquence peuvent s'écrire :

$$ZC_R(k) = e^{-j\pi Rk^2/\Sigma} = e^{j\varphi_R(k)} \tag{11}$$

avec $\varphi_R(k) = -\dfrac{\pi Rk^2}{\Sigma}$. La séquence ZC peut être considérée comme un chirp dont la fréquence instantanée prend les valeurs discrètes :

$$f_R(k) = \frac{1}{2\pi} \frac{d\varphi_R(k)}{dk} = -\frac{R}{\Sigma} k \tag{12}$$

Dans le cas d'une séquence ZC, la modulation PPM de la séquence d'ondelettes l'expression (10) devient alors :

$$\varepsilon_k = \frac{\varphi_R(k)}{2\pi f_v^c} = -\frac{R}{2\Sigma f_v^c}k^2 \tag{13}$$

En utilisant une approximation de bande étroite de la fonction d'onde, $\psi(t)$, on comprend que cette modulation PPM est équivalente à une modulation de phase des ondelettes à l'aide de la loi de phase continue, $\varphi_R(t)$, de période $T_{acq} = \Sigma T_p$, définie sur $[0, T_{acq}]$ par:

$$\varphi_R(t) = -\frac{R\pi}{\Sigma T_p^2}t^2 = \pi\mu_R t^2 \tag{14}$$

avec $\mu_R = -\dfrac{R}{\Sigma T_p^2} = -\dfrac{Rf_p}{T_{acq}}$. Il en résulte que la fréquence instantanée $\dfrac{1}{2\pi}.\dfrac{d\varphi_R}{dt}$ subit une variation linéaire de pente $\mu_R$.

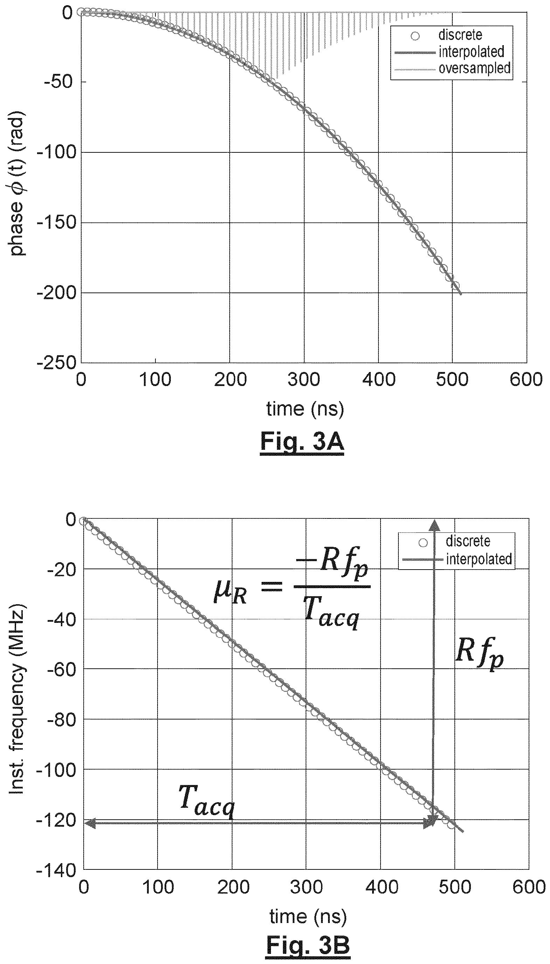

A titre d'exemple, on a respectivement représenté en Fig. 3A et 3B l'évolution de la phase et de la fréquence instantanée le long d'une séquence de Zadoff-Chu. Plus précisément, les courbes représentées correspondent à une séquence de longueur $\Sigma = 64$, de racine $R = 1$ et une cadence de $f_p =$125 MHz. On remarque notamment que la fréquence instantanée varie linéairement le long de la séquence, avec une pente $\mu_R$.

Compte tenu des propriétés de changement d'échelle de la fonction de Dirac et du caractère bande étroite du spectre de l'ondelette, on peut montrer que :

$$\tilde{H}(f) \approx \Psi(f).2\pi f_p FT\left(\sum_{k=1}^{\Sigma} e^{-ik\varphi(t)}\right) \tag{15}$$

où $\tilde{H}(f)$ et $\Psi(f)$ sont respectivement les spectres de $\tilde{p}(t)$ et $\psi(t)$, $FT(.)$ signifie la transformée de Fourier et $\varphi(t)$ est une loi de phase de période $T_{acq}$, vérifiant sur $[0, T_{acq}]$ que $\varphi(kT_p) = \arg(\eta_k) = 2\pi f_v^c \varepsilon_k$.

L'expression (15) peut être réécrite sous la forme suivante :

$$\tilde{H}(f) \approx \sum_{k=1}^{\Sigma} \tilde{H}_k(f - kf_p) \tag{16}$$

où $\tilde{H}_k(f) = 2\pi f_p \psi(kf_p)FT(e^{-jk\varphi(t)})$ est la réponse fréquentielle d'un filtre $\tilde{H}_k$ associé à la $k$ ème bande de repliement. En comparant avec l'expression (6), on voit que le spectre $\tilde{H}(f)$ n'est plus un spectre de raies mais présente des bandes élémentaires de largeur $f_p$. On remarque en outre que, par rapport à un échantillonneur WBS conventionnel, le terme $FT(e^{-ik\varphi(t)})$ introduit une modulation de phase liée à la séquence CAZAC.

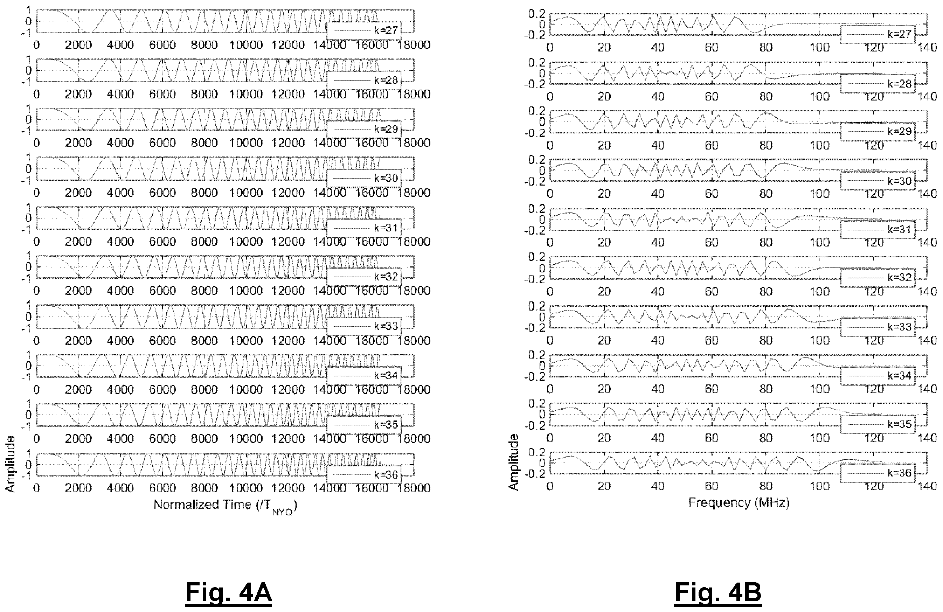

La Fig. 4A représente l'évolution de la partie réelle de $\Re\left(e^{-ik\varphi(t)}\right)$ au cours du temps, pour différents indices de repliement $k$ et la Fig. 4B représente l'évolution de la partie réelle $\Re\left(FT\left(e^{-ik\varphi(t)}\right)\right)$ en fonction de la fréquence pour ces mêmes indices.

Cette représentation a été donnée à titre d'exemple pour une séquence de Zadoff-Chu de longueur $\Sigma = 64$ et de racine $r =$1, une cadence de $f_p =$125 MHz et une fréquence centrale d'ondelette $f_v^c = 4$ GHz.

Les Figs. 4A et 4B sont conformes au fait que la transformée de Fourier d'une séquence de Zadoff-Chu est encore une séquence de Zadoff-Chu. La bande spectrale $\tilde{H}_k(f)$ apparaissant dans l'expression (16) est le résultat d'une modulation (dans l'espace des fréquences) avec une séquence de Zadoff-Chu de racine $kR$.

Etant donné que deux séquences de Zadoff-Chu de même longueur et de racines différentes (ici $kR$, $k'R$ avec $k \neq k'$) ont une faible valeur d'inter-corrélation (on peut d'ailleurs montrer que c'est une valeur minimale pour des séquences ayant une fonction d'autocorrélation parfaite), les différentes bandes spectrales sont décorrélées.

De manière plus générale, la modulation PPM à l'aide d'une séquence CAZAC conduit à un faible résultat d'intercorrélation entre deux bandes spectrales, $k' \neq k$ (l'intercorrélation entre $\tilde{H}_k(f)$ et $\tilde{H}_{k'}(f)$ est faible sauf pour $k' = k$ ).

Il en résulte que, malgré le repliement de ces différentes bandes spectrales dans la bande de base

$$\left[ -\frac{f_p}{2}, +\frac{f_p}{2} \right]$$

en raison de l'échantillonnage passe-bande, il sera de discriminer les sous-bandes d'origine et de récupérer l'information du signal au moyen d'un filtrage adapté.

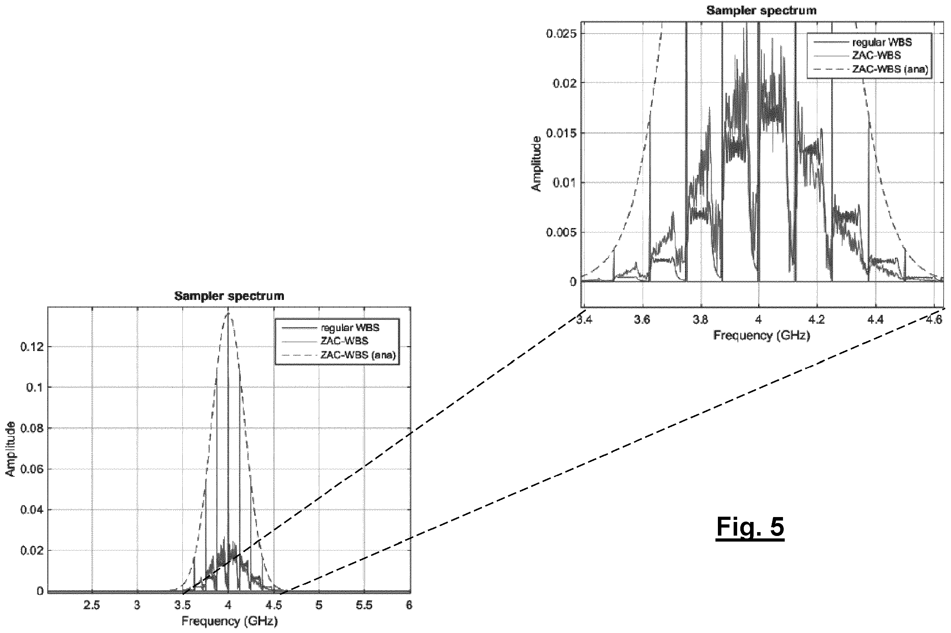

La Fig. 5 représente le spectre d'une séquence d'ondelettes modulées en position par la séquence de Zadoff-Chu illustrée précédemment.

On a également fait figurer à titre de comparaison le spectre de la même séquence d'ondelettes, en absence de modulation.

On vérifie qu'à un spectre de raies à intervalles $f_p$ a été substitué un spectre continu dont les propriétés d'intercorrélation sous-bande à sous-bande sont optimales. Comme précédemment annoncé, les raies du spectre du signal non modulé ainsi que les zéros du signal modulé coïncident avec les multiples de la fréquence de répétition $f_p$.

Une autre façon d'apprécier la décohérence entre bandes introduite par la modulation PPM dérivée d'une séquence ZC est de calculer la corrélation entre deux colonnes de la matrice de mesure.

Si l'on reprend le même formalisme que celui utilisé dans l'équation 2, le sous-échantillonnage passe-bande par séquence d'ondelettes (WBS) modulées en PPM peut être représenté par :

$$\mathbf{y} = \mathbf{R_T D} \odot \mathbf{W^H F^{-1} s} = \mathbf{R_T D} \odot \mathbf{As} \tag{17}$$

avec $\mathbf{A} = (\mathbf{FW})^H$, $\mathbf{D}$ la matrice de taille $\Sigma \times N$ dont les éléments sont $D(k,n) = \exp(-j2\pi\varepsilon_k n\Delta f)$ où $\Delta f = 1/T_{acq}$ et $\odot$ est le produit de Hadamard et $N = T_{acq} f_{Nyq}$.

La matrice d'acquisition représentant le sous-échantillonnage passe-bande par séquence d'ondelettes modulées en PPM, dénommée ci-après $\Delta$WBS peut donc s'écrire :

$$\mathbf{A_\Delta} = \mathbf{D} \odot (\mathbf{FW})^H \tag{18}$$

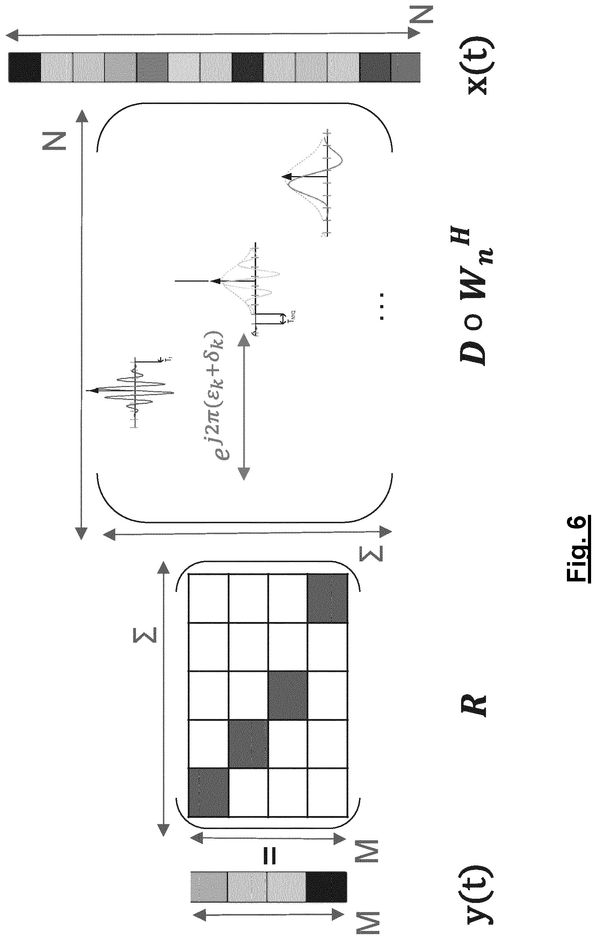

On a représenté en Fig. 6 la relation (17) sous la forme équivalente $\mathbf{y} = \mathbf{R_T D} \odot \mathbf{W^H x}$ où $\mathbf{x}$ est le vecteur de taille $N$ représentatif du signal échantillonné à la fréquence de Nyquist.

La matrice $\mathbf{D} \odot \mathbf{W^H}$ contient sur chaque ligne les échantillons (à la fréquence $f_{Nyq}$ ) d'une ondelette de fréquence $f_v^c$ centrée sur l'instant $\delta_k + \varepsilon_k$. La matrice $\mathbf{R_T}$ représente la sélection de $M$ échantillons parmi $\Sigma$ résultats de corrélation (dans le cas d'un échantillonnage non uniforme ou NU-$\Delta$WBS) dans l'intervalle de temps $T_{acq}$.

Dans le cas où la séquence CAZAC utilisée pour la modulation PPM est une séquence ZC, les éléments de la matrice $\mathbf{A}_\Delta^{norm}$ obtenue en normalisant les vecteurs colonnes de la matrice $\mathbf{A}_\Delta$ de manière à s'affranchir de l'amplitude de l'ondelette (terme gaussien dans le cas d'ondelettes de Gabor), peuvent s'écrire sous la forme :

$$A_\Delta^{norm}(k,n) = \exp\left(-j2\pi\left(\delta_k + \varepsilon_k\right)n\Delta f\right) = \exp\left(-j2\pi\left(\frac{k}{f_p} - \frac{Rk^2}{2f_v^c\Sigma}\right)n\Delta f\right) \tag{19}$$

Si l'on choisit $\Delta f = 1/T_{acq}$, la corrélation entre deux composantes du signal séparées de séparées de $f_p = \Sigma.\Delta f$, autrement dit entre deux colonnes de la matrice $\mathbf{A}_\Delta^{norm}$ séparées de $\Sigma$ peut s'exprimer sous la forme :

$$\Gamma_{n,n+\Sigma} = \sum_{k=1}^{\Sigma} \exp\left[ j2\pi\left(\frac{Rk^2}{2\Sigma f_v^c}\right)f_p \right] = \sum_{k=1}^{\Sigma} \exp\left[ j2\pi\left(\frac{Rk^2}{2}\right)\frac{\Delta f}{f_v^c} \right] \tag{20}$$

On voit que le résultat de corrélation n'est plus périodique en $f_p$ comme dans le cas non modulé (correspondant à $R = 0$, $\Gamma_{n,n+\Sigma} = \Sigma$) mais est une somme de termes complexes sur le cercle unité dont le module est faible.

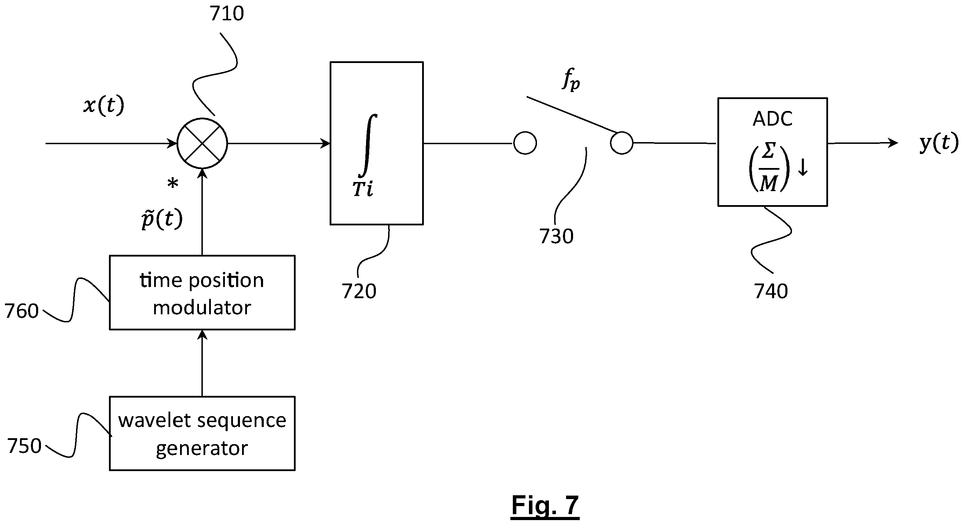

La Fig. 7 représente de manière schématique un échantillonneur ∆WBS selon un premier mode de réalisation de la présente invention.

Ce premier mode de réalisation correspond à une configuration série, c'est-à-dire à une seule branche d'échantillonnage. En d'autres termes, les différentes sous-bandes du signal d'entrée sont échantillonnées de manière séquentielle.

Le signal d'entrée, $x(t)$, est d'abord multiplié (produit hermitien) grâce au mélangeur 710 avec une séquence d'ondelettes modulées en position par une séquence CAZAC telle qu'une séquence ZC. Bien entendu, au lieu d'effectuer un produit hermitien dans le mélangeur 710, on pourra simplement générer des ondelettes conjuguées et effectuer une multiplication classique dans le mélangeur 710.

Le générateur de séquence d'ondelettes 750 fournit une séquence de base de durée $T_{acq}$, se répétant tous les $T_{acq}$. La séquence de base comporte $\Sigma$ ondelettes se succédant à la cadence $f_p$, où $\Sigma$ est la longueur de la séquence CAZAC. La période de la séquence d'ondelettes, dite période d'acquisition, est donc $T_{acq} = \Sigma T_p$. La fréquence $f_p$ est choisie égale à la fréquence de sous échantillonnage passe-bande, c'est-à-dire à $\sum_{i=1}^{N_b} B_i^w$ où $B_i^w$, $i = 1,...,N_b$ sont les largeurs des sous-bandes du signal d'entrée.

Les positions des ondelettes dans la séquence d'ondelettes sont modulées par le modulateur temporel 760. Plus précisément, les $\Sigma$ ondelettes d'une séquence de base sont modulées en position autour des instants $\delta_k = kT_p$ avec

$$\varepsilon_k = \frac{\arg(\eta_k)}{2\pi f_v^c}$$

où $\eta_k$, $k = 1, .., \Sigma$ sont les éléments de la séquence CAZAC.

Le produit hermitien en sortie du mélangeur est intégré par l'intégrateur 720 sur un intervalle de temps correspondant au support temporel de la fonction d'onde. Les résultats de corrélation en sortie de l'intégrateur se succèdent à la cadence $f_p$. Ces résultats de corrélation sont échantillonnés en 730 avec une fréquence $f_p$.

La séquence d'échantillons est, le cas échéant décimée de manière non-uniforme, et les échantillons ainsi obtenus sont ensuite convertis en numérique dans le convertisseur ADC 640. Par exemple tous les échantillons de la séquence pourront être conservés ($f_s = f_p$) ou bien seuls $M$ échantillons parmi $\Sigma$ pourront être retenus sur une période d'acquisition $T_{acq}$ (on a alors $f_s \leq f_p$), ce qui correspond à un facteur de décimation $\Sigma/M$.

Il est à noter que l'ensemble des éléments 710-630, 750, 760 opèrent sur des signaux analogiques. Le générateur et le modulateur pourront en outre être réalisés par un même circuit analogique comme décrit plus loin. Ainsi, l'échantillonneur ∆WBS n'est pas soumis aux contraintes de bande passante/ cadence d'échantillonnage inhérentes aux échantillonneurs à la fréquence de Nyquist.

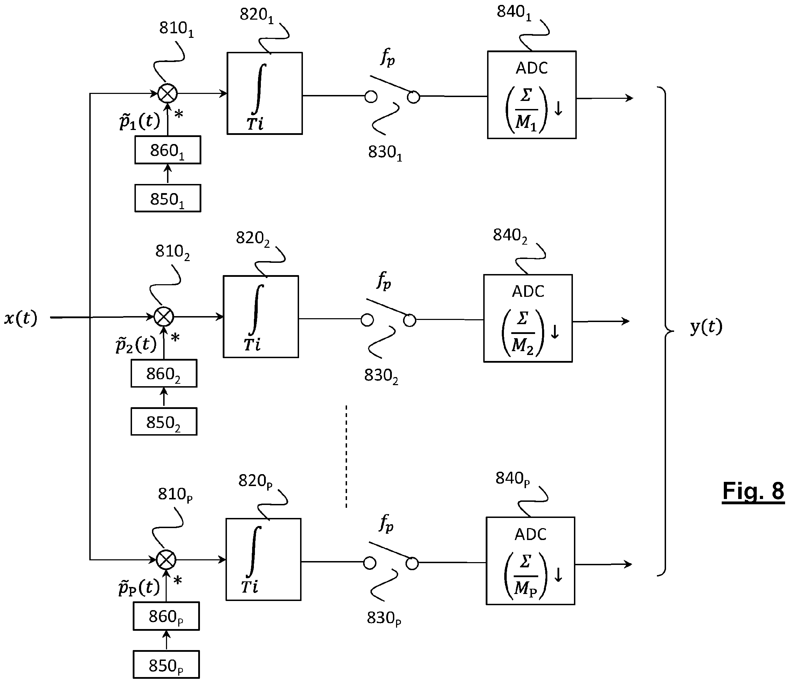

La Fig. 8 représente de manière schématique un échantillonneur ∆WBS selon un second mode de réalisation de la présente invention.

Ce second mode de réalisation correspond à une configuration à une pluralité $P$ de branches d'échantillonnage opérant en parallèle.

Par exemple, chaque branche d'échantillonnage peut correspondre à une bande du signal d'entrée. En d'autres termes, les différentes sous-bandes du signal d'entrée sont alors échantillonnées en parallèle et l'échantillonnage au sein d'une bande est réalisé de manière séquentielle.

De manière générale, les différentes branches peuvent correspondre à différentes CAZAC avec des périodes d'acquisition $T_{acq}^i$, identiques ou distinctes. Par exemple, les séquences CAZAC des différentes branches peuvent être des séquences ZC de même longueur $\Sigma$ mais avec des index $R$ différents et donc des excursions de fréquence $Rf_p$ différentes sur une même période d'acquisition $T_{acq}$. De préférence, on utilisera des séquences ZC avec des index $R$ premiers entre eux. Le fait d'utiliser des séquences CAZAC distinctes (par exemple d'index distincts) permet d'améliorer la diversité des résultats de corrélation et conduit à une meilleure réjection du repliement.

Le signal d'entrée $x(t)$ est distribué sur une pluralité $P$ de branches d'échantillonnage en parallèle, chaque branche $p$ ayant la même structure que celle représentée en Fig. 7, à savoir comportant un générateur de séquence d'ondelettes $850_p$, un modulateur de position temporelle $860_p$, un mélangeur $810_p$, un intégrateur $820_p$, un échantillonneur à la fréquence $f_s$, $830_p$, et un convertisseur analogique numérique, $840_p$.

Comme dans le premier mode de réalisation, l'échantillonnage peut être uniforme ou non uniforme.

Quel que soit le mode de réalisation, le signal en sortie de l'échantillonneur ∆WBS, noté $y(t)$ permet de reconstruire le signal d'entrée, $x(t)$. Pour ce faire, le signal $y(t)$ fait tout d'abord l'objet d'une transformée en z :

$$Y_d(z) = \sum_{n=0}^{+\infty} y(n) z^{-n} \qquad\qquad (21)$$

avec $y(n) = y(nT_p)$ , étant entendu qu'en cas d'échantillonnage non uniforme avec $f_s = \dfrac{M}{\Sigma} f_p$ les échantillons manquants sont remplacés par des zéros.

Le résultat $Y_d(z)$ est ensuite corrélé avec les réponses des filtres $\tilde{H}_k$ autrement dit fait l'objet d'un filtrage adapté avec ces filtres dans le domaine fréquentiel. Les spectres obtenus, soit $\Lambda_k(f) = \left[ Y_d(z) * H_k(z) \right]_{z=e^{j2\pi f_p}}$ (où * représente la corrélation) sont ensuite transposés en fréquence puis sommés pour obtenir le spectre de bandes :

$$\Lambda(f) = \sum_{k=0}^{\kappa-1} \Lambda_k(f) \qquad\qquad (22)$$

où $\kappa = \dfrac{f_{Nyq}}{f_p}$. Le spectre $\Lambda(f)$ est celui d'un signal issu d'un échantillonnage WBS conventionnel, le signal $x(t)$ pouvant alors s'en déduire comme décrit dans la demande EP-A-3319236 précitée.

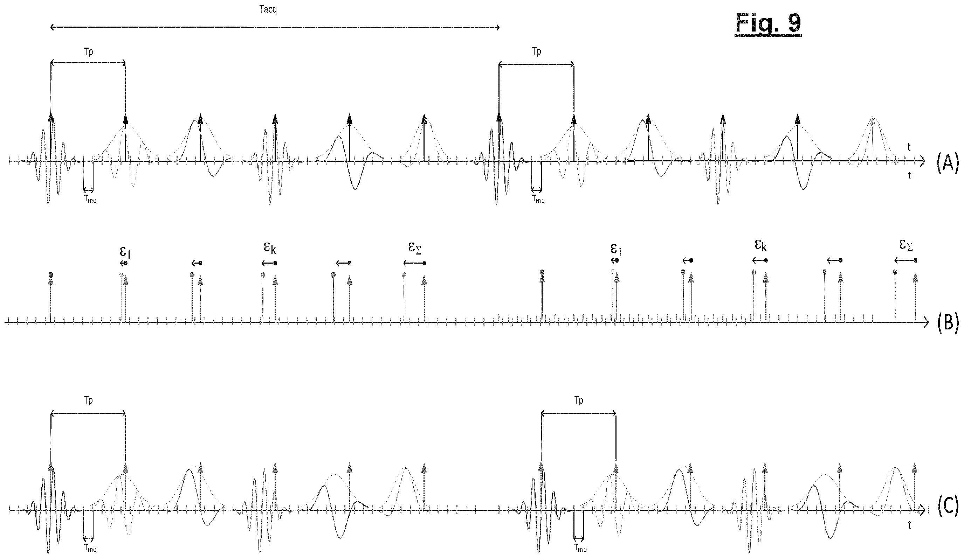

La Fig. 9 représente un exemple de séquence d'ondelettes modulées en position par une séquence CAZAC, telle qu'utilisée dans l'échantillonneur de la Fig. 7 ou dans une branche d'échantillonnage de la Fig. 8.

Comme précédemment indiqué, la séquence d'ondelettes présente une période $T_{acq} = \Sigma T_p$. La ligne (A) représente la séquence non modulée, telle que fournie par le générateur 710 ou l'un des générateurs $850_p$. La ligne (B) représente les décalages temporels, $\varepsilon_k$ issus de la séquence CAZAC $\eta_k$, $k = 1, .., \Sigma$. Enfin, la ligne (C) montre la séquence d'ondelettes modulées en position par les décalages temporels issus de la séquence CAZAC. Les ondelettes sont désormais centrées sur les instants $kT_p + \varepsilon_k$ .

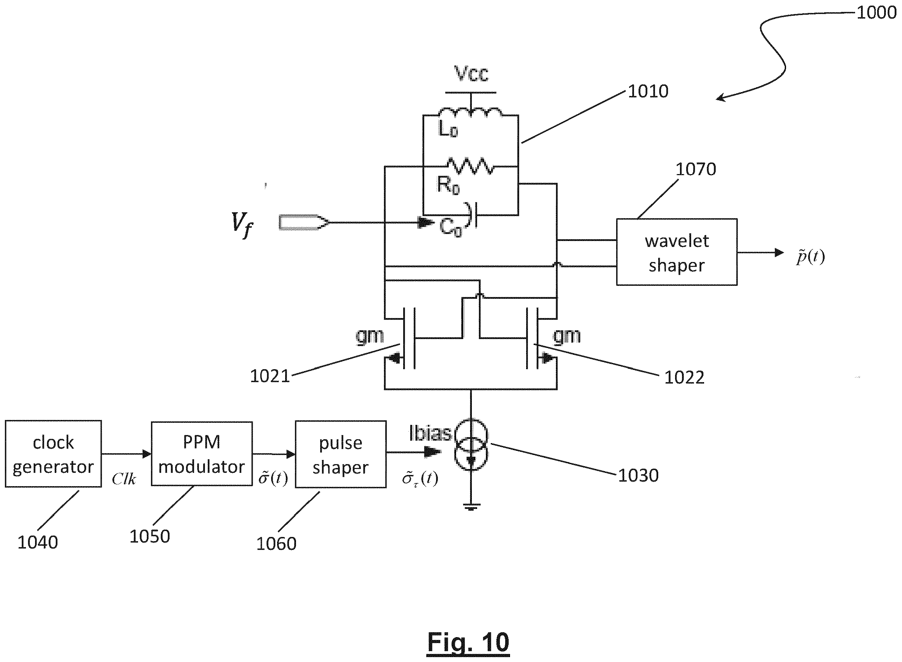

La Fig. 10 représente de manière schématique un générateur de séquence d'ondelettes modulées en PPM pour l'échantillonneur ΔWBS de la Fig. 8 ou de la Fig. 9.

Ce générateur de séquence d'ondelettes est particulièrement avantageux dans la mesure où il combine la fonction de génération des ondelettes et celle de modulation de position temporelle.

Le générateur 1000 est basé sur un oscillateur VCO commuté à la fréquence de répétition $f_p$. L'oscillateur comprend un circuit oscillant LC, 1010, utilisant une varicap commandée par une tension $V_f$ de manière à pouvoir contrôler la fréquence d'oscillation du circuit oscillant. La tension $V_f$ est choisie égale de manière à ce que le circuit oscillant oscille à la fréquence centrale des ondelettes, $f_v^c$ . La tension $V_f$ peut donc varier à chaque nouvelle période $T_p$. Le générateur comprend en outre de manière classique une paire de transistors croisés, 1021, 1022, montée entre les bornes du circuit oscillant LC et une source commune de courant, 1030. La source de courant est commutée à l'aide d'un signal de commutation, $\tilde{\sigma}_\tau(t)$, obtenu en modulant les positions temporelles des fronts de montée d'une horloge *Clk* à la fréquence $f_p$ .

L'horloge *Clk* présente une faible gigue de phase. Elle peut être générée au moyen du circuit d'horloge 1040, directement par un résonateur à quartz, voire par un oscillateur VCO verrouillé au moyen d'une boucle à verrouillage de phase sur un signal de basse fréquence, stable en fréquence et en phase. La fréquence du signal d'horloge est modulée par le circuit de modulation de fréquence, 1050. Celui-ci module périodiquement la fréquence de l'horloge selon une loi linéaire de pente $\mu_R$ sur la durée $T_{acq}$ de séquence de base. Autrement dit, la fréquence instantanée de l'horloge ainsi modulée parcourt une excursion de $Rf_p$ sur la durée $T_{acq} = \Sigma T_p$. Le signal d'horloge ainsi modulé en fréquence, $\tilde{\sigma}(t)$, est mis en forme numériquement dans un module de mise en forme d'impulsion, 960. Ce module de mise en forme restreint la durée des impulsions d'horloge à la durée $\tau$. Le signal ainsi mis en forme est utilisé comme signal de commutation $\tilde{\sigma}_\tau(t)$ de la source de courant.

La phase initiale et la polarité de l'impulsion initiale générée par le générateur 900 sont fixées en forçant le circuit oscillant à démarrer dans une direction. Cela peut être réalisé en introduisant un déséquilibre entre les 2 branches, par exemple en prévoyant des transistors MOS ayant des rapports géométriques différents ou encore en ajoutant une charge capacitive dans l'une des branches.

Le signal en sortie de l'oscillateur commuté est ensuite filtré par un filtre de mise en forme analogique, 970, de manière à ce que chaque train d'oscillations sinusoïdales ait l'enveloppe de la fonction d'onde. Alternativement, la forme de la fonction d'onde peut être imposée de manière numérique en modulant l'amplitude du signal $\tilde{\sigma}(t)$ dans le module de mise en forme 960.

On pourra prévoir deux générateurs 900 fonctionnant avec signaux d'horloge *Clk* en quadrature de manière à pouvoir à disposer de signaux d'ondelettes complexes et à effectuer le produit hermitien dans le mélangeur d'entrée. L'horloge en quadrature pourra être inversée de manière à obtenir simplement les signaux conjugués et utiliser un mélangeur conventionnel sur les voies I et Q.

La Fig. 10 donne à titre d'exemple illustratif un chronogramme des signaux en différents points du générateur de séquence d'ondelettes de la Fig. 9.

La ligne (A) représente le signal d'horloge *Clk* généré par le circuit d'horloge 950. La ligne (B) représente le signal d'horloge de commutation $\sigma(t)$, en sortie du circuit de modulation de fréquence. On remarque que les fronts de montée de l'horloge de commutation sont décalés de $\varepsilon_k$ par rapport aux fronts de montée de l'horloge *Clk* . La ligne (C) représente le signal de commutation $\sigma_\tau(t)$ obtenu par mise en forme numérique du signal d'horloge de commutation en réduisant les impulsions d'horloge à la largeur $\tau$ de l'ondelette. On a représenté à la ligne (D) le signal en sortie de l'oscillateur lorsque celui-ci n'est pas commuté (sinusoïde à la fréquence centrale de l'ondelette $f_v^c$ ) . Le signal en sortie de l'oscillateur commuté est représenté à la ligne (E) : celui-ci est constitué de trains d'ondes à la fréquence $f_v^c$ démarrant aux instants $kT_p + \varepsilon_k$. Ce signal est mis en forme dans le filtre de mise en forme 960 pour fournir la séquence d'ondelettes $\tilde{p}(t)$ .

## Revendications

1. Méthode d'échantillonnage passe-bande d'un signal analogique, le spectre dudit signal présentant un ensemble de sous-bandes, ledit signal étant corrélé avec une séquence d'ondelettes se succédant avec une cadence $f_p$ égale à la somme des largeurs desdites sous-bandes, les fréquences centrales des ondelettes appartenant aux dites sous-bandes, **caractérisée en ce que** les positions respectives des ondelettes dans la séquence sont modulées temporellement au moyen des arguments des éléments successifs d'une séquence CAZAC, les résultats de corrélation avec la séquence d'ondelettes ainsi modulées en position étant échantillonnés avec une fréquence $f_s \leq f_p$ et convertis en numérique.

2. Méthode d'échantillonnage passe-bande selon la revendication 1, **caractérisée en ce que** la séquence d'ondelettes est formée d'une pluralité de séquences de base, chaque séquence de base étant de durée $\sum T_p$ avec $T_p = 1/f_p$, la séquence CAZAC étant de longueur $\Sigma$, les positions respectives des ondelettes dans une séquence de base étant modulées temporellement au moyen des arguments des éléments successifs de la séquence CAZAC.

3. Méthode d'échantillonnage passe-bande selon la revendication 2, **caractérisée en ce que** la séquence CAZAC est formée par les éléments complexes $\eta_k$, $k = 1,..,\Sigma$ où les positions temporelles des ondelettes de la séquence sont les instants $kT_p + \varepsilon_k$ avec $T_p = 1/f_p$ et $\varepsilon_k = \dfrac{\arg(\varepsilon_k)}{2\pi f_c^v}$ , où $f_c^v$ est la fréquence centrale des ondelettes.

4. Méthode d'échantillonnage passe-bande selon la revendication 3, **caractérisée en ce que** la séquence CAZAC est une séquence de Zadoff-Chu dont les éléments sont définis par :

$$ZC_R(k) = e^{-j\pi Rk(k-1)/\Sigma} \quad ,$$

si la longueur $\Sigma$ de la séquence est impaire, et

$$ZC_R(k) = e^{-j\pi R(k-1)(k-1)/\Sigma} ,$$

si la longueur $\Sigma$ de la séquence est paire et où

$R,\Sigma$ sont des entiers positifs premiers entre eux, $R$ représentant l'excursion de la fréquence instantanée, exprimée comme multiple de $f_p$, le long de la séquence et $k \in [1,\Sigma]$.

5. Méthode d'échantillonnage passe-bande selon la revendication 4, **caractérisée en ce que** la séquence d'ondelettes est formée d'au moins une première et une seconde séquence de base, la première séquence de base étant constituée d'ondelettes dont les positions sont modulées temporellement au moyen des arguments des éléments successifs d'une première séquence CAZAC et la seconde séquence de base étant constituée d'ondelettes dont les positions sont modulées temporellement au moyen des arguments des éléments successifs d'une seconde séquence CAZAC, les première et seconde séquences CAZAC étant de même longueur mais d'excursions de fréquence instantanée distinctes.

6. Méthode d'échantillonnage passe-bande selon la revendication 4, **caractérisée en ce que** le spectre du signal analogique comprend une première et une seconde sous-bande, et que la séquence d'ondelettes est formée d'au moins une première et une seconde séquence de base, la première étant constituée d'ondelettes dont la fréquence centrale appartient à la première sous-bande et la seconde étant constituée d'ondelettes dont la fréquence centrale appartient à la seconde sous-bande.

7. Méthode d'échantillonnage passe-bande selon l'une des revendications précédentes, **caractérisée en ce que** les ondelettes sont des fonctions de Gabor.

8. Méthode d'échantillonnage passe-bande selon l'une des revendications 1-6, **caractérisée en ce que** les ondelettes sont des ondelettes de Morlet .

9. Dispositif d'échantillonnage passe-bande d'un signal analogique par échantillonnage de bande passante, le spectre dudit signal présentant un ensemble de sous-bandes, le dispositif comprenant au moins une branche d'échantillonnage comportant :

un générateur de séquence d'ondelettes (650), les ondelettes de ladite séquence se succédant avec une cadence $f_p$ égale à la somme des largeurs desdites sous-bandes ;
un corrélateur (610, 620) pour corréler le signal analogique avec ladite séquence d'ondelettes et fournir des résultats de corrélation à la cadence $f_p$ ;
un échantillonneur (630) pour échantillonner les résultats de corrélation à la cadence $f_p$ ;
un convertisseur analogique numérique (640) pour décimer et convertir en numérique les résultats de corrélation ainsi échantillonnés ;
**caractérisé en ce qu'**il comprend en outre :
un modulateur de position temporelle (660) destiné à moduler les positions temporelles des ondelettes de la séquence d'ondelettes générée par le générateur, avant corrélation avec le signal analogique, la modulation temporelle étant réalisée au moyen des arguments des éléments successifs d'une séquence CAZAC.

10. Dispositif d'échantillonnage passe-bande selon la revendication 9, **caractérisé en ce que** la séquence CAZAC est une séquence de Zadoff-Chu dont les éléments sont définis par :

$$ZC_R(k) = e^{-j\pi Rk(k-1)/\Sigma} \quad ,$$

si la longueur $\Sigma$ de la séquence est impaire, et

$$ZC_R(k) = e^{-j\pi R(k-1)(k-1)/\Sigma} ,$$

si la longueur $\Sigma$ de la séquence est paire et où
$R,\Sigma$ sont des entiers positifs premiers entre eux, $R$ représentant l'excursion de la fréquence instantanée, exprimée comme multiple de $f_p$, le long de la séquence et $k \in [1,\Sigma]$.

11. Dispositif d'échantillonnage passe-bande selon la revendication 10, **caractérisé en ce que** le générateur de séquence d'ondelettes comprend un oscillateur VCO commuté par un signal de commutation, l'oscillateur VCO comprenant :

un circuit oscillant (910) dont la fréquence est commandée pour être égale à la fréquence centrale des ondelettes de la séquence ;
une paire de transistors croisés (921,922) , montés entre les bornes du circuit oscillant ;
une source de courant commune (930), la source de courant étant commutée par le signal de commutation ;
un générateur d'horloge (940) pour générer un signal d'horloge à la fréquence $f_p$ ;
un modulateur de fréquence (950) pour moduler linéairement la fréquence du signal d'horloge de manière à ce que celle-ci varie linéairement du début à la fin de la séquence d'ondelettes avec une excursion de $Rf_p$ .

12. Dispositif d'échantillonnage passe-bande selon la revendication 10, **caractérisé en ce que** le générateur de séquence d'ondelettes comprend en outre un module de mise en forme d'impulsion (960), transformant chaque impulsion du signal d'horloge en une impulsion ayant la forme d'onde d'une ondelette.

13. Dispositif d'échantillonnage passe-bande selon l'une des revendications 9-12, **caractérisée en ce que** les ondelettes sont des fonctions de Gabor.

14. Dispositif d'échantillonnage passe-bande selon l'une des revendications 9-12, **caractérisée en ce que** les ondelettes sont des ondelettes de Morlet.

**Patentansprüche**

1. Bandpass-Abtastverfahren für ein analoges Signal, wobei das Spektrum des Signals eine Reihe von Teilbändern aufweist und das Signal mit einer Folge von Wavelets korreliert, die mit einer Rate $f_p$ aufeinander folgen, die gleich der Summe der Breiten der Teilbänder ist, wobei die Mittenfrequenzen der Wavelets zu den Teilbändern gehören, **dadurch gekennzeichnet, dass** die jeweiligen Positionen der Wavelets in der Folge mit Hilfe von Argumenten der aufeinanderfolgenden Elemente einer CAZAC-Folge zeitlich moduliert werden, wobei die Ergebnisse der Korrelation mit der Folge von dabei positionsmodulierten Wavelets mit einer Frequenz $f_s \le f_p$ abgetastet und digital umgewandelt werden.

2. Bandpass-Abtastverfahren nach Anspruch 1, **dadurch gekennzeichnet, dass** die Folge von Wavelets aus einer Vielzahl von Basisfolgen gebildet wird, wobei jede Basisfolge die Dauer $\Sigma T_p$ aufweist, wobei $T_p = 1/f_p$, die CAZAC-Folge die Länge $\Sigma$ aufweist und die jeweiligen Positionen der Wavelets in einer Basisfolge mit Hilfe von Argumenten der aufeinanderfolgenden Elemente der CAZAC-Folge zeitlich moduliert werden.

3. Bandpass-Abtastverfahren nach Anspruch 2, **dadurch gekennzeichnet, dass** die CAZAC-Folge durch die komplexen Elemente $\eta_k$, k = 1, ..., $\Sigma$ gebildet wird, wobei die zeitlichen Positionen der Wavelets der Folge die Zeitpunkte

$$\varepsilon_k = \frac{\arg\left(\varepsilon_k\right)}{2\pi f_c^v} ,$$

$kT_p + \varepsilon_k$ sind, wobei $T_p = 1/f_p$ und , wobei $f_c^v$ die Mittenfrequenz der Wavelets ist.

4. Bandpass-Abtastverfahren nach Anspruch 3, **dadurch gekennzeichnet, dass** die CAZAC-Folge eine Zadoff-Chu-Folge ist, deren Elemente definiert sind durch:

$$ZC_R(k) = e^{-j\pi Rk(k-1)/\Sigma} ,$$

wenn die Länge $\Sigma$ der Folge ungerade ist, und

$$ZC_R(k) = e^{-j\pi R(k-1)(k-1)/\Sigma} ,$$

wenn die Länge $\Sigma$ der Folge gerade ist und wobei $R,\Sigma$ positive ganze Zahlen sind, die teilerfremd sind, wobei $R$ für die Abweichung der momentanen Frequenz steht, ausgedrückt als Vielfaches von $f_p$, entlang der Folge und $k \in [1,\Sigma]$.

5. Bandpass-Abtastverfahren nach Anspruch 4, **dadurch gekennzeichnet, dass** die Folge von Wavelets aus mindestens einer ersten und einer zweiten Basisfolge gebildet wird, wobei die erste Basisfolge aus Wavelets besteht, deren Positionen mit Hilfe von Argumente aufeinanderfolgender Elemente einer ersten CAZAC-Folge zeitlich moduliert werden, und die zweite Basisfolge aus Wavelets besteht, deren Positionen mit Hilfe von Argumenten aufeinanderfolgender Elemente einer zweiten CAZAC-Folge zeitlich moduliert werden, wobei die erste und die zweite CAZAC-Folge die gleiche Länge, aber unterschiedliche momentane Frequenzabweichungen aufweisen.

6. Bandpass-Abtastverfahren nach Anspruch 4, **dadurch gekennzeichnet, dass** das Spektrum des analogen Signals ein erstes und ein zweites Teilband umfasst und dass die Folge von Wavelets aus mindestens einer ersten und einer zweiten Basisfolge gebildet wird, wobei die erste aus Wavelets besteht, deren Mittenfrequenzen zum ersten Teilband gehören, und die zweite aus Wavelets besteht, deren Mittenfrequenzen zum zweiten Teilband gehören.

7. Bandpass-Abtastverfahren nach einem der vorhergehenden Ansprüche, **dadurch gekennzeichnet, dass** die Wavelets Gabor-Funktionen sind.

8. Bandpass-Abtastverfahren nach einem der Ansprüche 1-6, **dadurch gekennzeichnet, dass** die Wavelets Morlet-Wavelets sind.

9. Vorrichtung zur Bandpassabtastung eines analogen Signals durch Bandbreitenabtastung, wobei das Spektrum des Signals einen Satz von Teilbändern aufweist, wobei die Vorrichtung mindestens einen Abtastbereich umfasst, der Folgendes umfasst:

einen Wavelet-Folgengenerator (650), wobei die Wavelets der Folge mit einer Rate $f_p$ aufeinander folgen, die gleich der Summe der Breiten der Teilbänder ist;
einen Korrelator (610, 620) zum Korrelieren des analogen Signals mit der Folge von Wavelets und zum Bereitstellen von Korrelationsergebnissen mit der Rate $f_p$;
eine Abtasteinrichtung (630) zum Abtasten der Korrelationsergebnisse mit der Rate $f_p$;
einen Analog-Digital-Wandler (640) zum Dezimieren und digitalen Umwandeln der dabei abgetasteten Korrelationsergebnisse;
**dadurch gekennzeichnet, dass** sie ferner Folgendes umfasst:
einen zeitlichen Positionsmodulator (660), der dazu bestimmt ist, die zeitlichen Positionen der Wavelets der vom Generator erzeugten Folge von Wavelets vor der Korrelation mit dem analogen Signal zu modulieren, wobei die zeitliche Modulation mit Hilfe von Argumenten aufeinanderfolgender Elemente einer CAZAC-Folge durchgeführt wird.

10. Bandpass-Abtastvorrichtung nach Anspruch 9, **dadurch gekennzeichnet, dass** die CAZAC-Folge eine Zadoff-Chu-Folge ist, deren Elemente definiert sind durch:

$$ZC_R(k) = e^{-j\pi Rk(k-1)/\Sigma},$$

wenn die Länge $\Sigma$ der Folge ungerade ist, und

$$ZC_R(k) = e^{-j\pi R(k-1)(k-1)/\Sigma},$$

wenn die Länge $\Sigma$ der Folge gerade ist und wobei $R, \Sigma$ positive ganze Zahlen sind, die teilerfremd sind, wobei $R$ für die Abweichung der momentanen Frequenz steht, ausgedrückt als Vielfaches von $f_p$, entlang der Folge und $k \in [1, \Sigma]$.

11. Bandpass-Abtastvorrichtung nach Anspruch 10, **dadurch gekennzeichnet, dass** der Wavelet-Folgengenerator einen spannungsgesteuerten Oszillator (VCO-Oszillator) umfasst, der durch ein Schaltsignal geschaltet wird, wobei der VCO-Oszillator Folgendes umfasst:

einen Schwingkreis (910), dessen Frequenz so gesteuert wird, dass sie gleich der Mittenfrequenz der Wavelets der Folge ist;
ein Paar gekreuzter Transistoren (921, 922), die zwischen den Anschlüssen des Schwingkreises montiert sind;

eine gemeinsame Stromquelle (930), wobei die Stromquelle durch das Schaltsignal geschaltet wird;

einen Taktgenerator (940) zum Erzeugen eines Taktsignals mit der Frequenz $f_p$;

einen Frequenzmodulator (950) zum linearen Modulieren der Frequenz des Taktsignals in einer solchen Weise, dass sie vom Anfang bis zum Ende der Folge von Wavelets mit einer Abweichung von $Rf_p$ linear variiert.

12. Bandpass-Abtastvorrichtung nach Anspruch 10, **dadurch gekennzeichnet, dass** der Wavelet-Folgengenerator ferner ein Impulsformungsmodul (960) umfasst, das jeden Impuls des Taktsignals in einen Impuls mit der Wellenform eines Wavelets umwandelt.

13. Bandpass-Abtastvorrichtung nach einem der Ansprüche 9-12, **dadurch gekennzeichnet, dass** die Wavelets Gabor-Funktionen sind.

14. Bandpass-Abtastvorrichtung nach einem der Ansprüche 9-12, **dadurch gekennzeichnet, dass** die Wavelets Morlet-Wavelets sind.

**Claims**

1. A method for band-pass sampling of an analogue signal, the spectrum of said signal having a set of sub-bands, said signal being correlated with a sequence of wavelets succeeding one another with a rate $f_p$ equal to the sum of the widths of said sub-bands, the central frequencies of the wavelets belonging to said sub-bands, **characterised in that** the respective positions of the wavelets in the sequence are modulated temporally by means of the arguments of the successive elements of a CAZAC sequence, the correlation results with the sequence of wavelets thus modulated in position being sampled with a frequency $f_s \leq f_p$ and converted into digital.

2. The band-pass sampling method according to claim 1, **characterised in that** the wavelet sequence is formed of a plurality of basic sequences, each basic sequence having a duration $\sum T_p$ with $T_p = 1/f_p$, the CAZAC sequence being of length $\sum$, the respective positions of the wavelets in a basic sequence being modulated temporally by means of the arguments of the successive elements of the CAZAC sequence.

3. The band-pass sampling method according to claim 2, **characterised in that** the CAZAC sequence is formed by the complex elements $\eta_k$, k = 1,.., $\sum$ where the temporal positions of the wavelets of the sequence are the instants

$KT_p + \varepsilon_k$ with $T_p = 1/f_p$ and $\quad \varepsilon_k = \dfrac{\arg(\varepsilon_k)}{2\pi f_c^\nu}$ , where $f_c^\nu$ is the central frequency of the wavelets.

4. The band-pass sampling method according to claim 3, **characterised in that** the CAZAC sequence is a Zadoff-Chu sequence whose elements are defined by:

$$ZC_R(k) = e^{-j\pi Rk(k-1)/\sum},$$

if the length $\sum$ of the sequence is odd, and

$$ZC_R(k) = e^{-j\pi R(k-1)(k-1)/\sum},$$

if the length $\sum$ of the sequence is even and where

R, $\sum$ are mutually prime positive integers, R representing the excursion of the instantaneous frequency, expressed as a multiple of $f_p$, along the sequence and $k \in [1, \sum]$.

5. The band-pass sampling method according to claim 4, **characterised in that** the wavelet sequence is formed of at least a first and a second basic sequence, the first basic sequence consisting of wavelets whose positions are modulated temporally by means of the arguments of the successive elements of a first CAZAC sequence and the second basic sequence consisting of wavelets whose positions are temporally modulated by means of the arguments of the successive elements of a second CAZAC sequence, the first and second CAZAC sequences being of the same length but of distinct instantaneous frequency excursions.

6. The band-pass sampling method according to claim 4, **characterised in that** the spectrum of the analogue signal comprises a first and a second sub-band, and that the wavelet sequence is formed of at least a first and a second basic sequence, the first consisting of wavelets whose central frequency belongs to the first sub-band and the second consisting of wavelets whose central frequency belongs to the second sub-band.

7. The band-pass sampling method according to one of the preceding claims, **characterised in that** the wavelets are Gabor functions.

8. The band-pass sampling method according to one of claims 1-6, **characterised in that** the wavelets are Morlet wavelets.

9. A device for band-pass sampling of an analogue signal by bandwidth sampling, the spectrum of said signal having a set of sub-bands, the device comprising at least one sampling branch including:

> a wavelet sequence generator (650), the wavelets of said sequence succeeding one another with a rate $f_p$ equal to the sum of the widths of said sub-bands;
> a correlator (610, 620) for correlating the analogue signal with said wavelet sequence and providing correlation results at the rate $f_p$;
> a sampler (630) for sampling the correlation results at the rate $f_p$;
> an analogue-to-digital converter (640) for decimating and converting the correlation results thus sampled into digital;
> **characterised in that** it further comprises:
> a temporal position modulator (660) intended to modulate the temporal positions of the wavelets of the wavelet sequence generated by the generator, before correlation with the analogue signal, the temporal modulation being carried out by means of the arguments of the successive elements of a CAZAC sequence.

10. The band-pass sampling device according to claim 9, **characterised in that** the CAZAC sequence is a Zadoff-Chu sequence whose elements are defined by:

$$ZC_R(k) = e^{-j\pi Rk(k-1)/\Sigma},$$

if the length $\Sigma$ of the sequence is odd, and

$$ZC_R(k) = e^{-j\pi R(k-1)(k-1)/\Sigma},$$

if the length $\Sigma$ of the sequence is even and where
R, $\Sigma$ are mutually prime positive integers, R representing the excursion of the instantaneous frequency, expressed as a multiple of $f_p$, along the sequence and $k \in [1, \Sigma]$.

11. The band-pass sampling device according to claim 10, **characterised in that** the wavelet sequence generator comprises a VCO oscillator switched by a switching signal, the VCO oscillator comprising:

> an oscillating circuit (910) whose frequency is controlled to be equal to the central frequency of the wavelets in the sequence;
> a pair of crossed transistors (921,922), mounted between the terminals of the oscillating circuit;
> a common current source (930), the current source being switched by the switching signal;
> a clock generator (940) for generating a clock signal at the frequency $f_p$;
> a frequency modulator (950) for linearly modulating the frequency of the clock signal so that it varies linearly from the start to the end of the wavelet sequence with an excursion of $Rf_p$.

12. The band-pass sampling device according to claim 10, **characterised in that** the wavelet sequence generator further comprises a pulse shaping module (960), transforming each pulse of the clock signal into a pulse having the waveform of a wavelet.

13. The band-pass sampling device according to one of claims 9-12, **characterised in that** the wavelets are Gabor functions.

**14.** The band-pass sampling device according to one of claims 9-12, **characterised in that** the wavelets are Morlet wavelets.

Fig. 1

$$T_s = \gamma T_{Nyq}$$

$\tau$

$p(t)$

$T_{Nyq}$

t

EP 3 681 040 B1

$x(t)$

110

120

$\int_{T_s}$

130

$f_s$

140

ADC

$M/Ns\downarrow$

150

**Fig. 2**

Fig. 3A

$$\mu_R = \frac{-Rf_p}{T_{acq}}$$

Fig. 3B

Fig. 4B

Fig. 4A

Fig. 5

**Fig. 6**

**Fig. 7**

EP 3 681 040 B1

Fig. 8

**Fig. 9**

**Fig. 10**

Fig. 11

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

• EP 3319236 A

**Littérature non-brevet citée dans la description**

• **M. PELISSIER et al.** Non-uniform wavelet sampling for RF analog-to-information conversion. *IEEE Transactions on Circuits and Systems I,* Août 2017